# EUROPEAN PATENT APPLICATION

(11) **EP 2 579 292 A1**
(43) Date of publication of application: **10.04.2013**
(21) Application number: 11786700.2
(22) Date of filing: 26.05.2011
(51) Int. Cl.: H01J 37/295, H01J 37/09, H01J 37/24, H01J 37/26

(54) **TRANSMISSION INTERFERENCE MICROSCOPE**

(30) Priority: 28.05.2010 JP 2010122448
(71) Applicant: Hitachi High-Technologies Corporation, Tokyo 105-8717 (JP)
(72) Inventor: NAGAOKI, Isao, Ibaraki 312-8504 (JP); TANIGAKI, Toshiaki, Ibaraki 312-0033 (JP)
(74) Representative: Strehl Schübel-Hopf & Partner
(86) International application number: PCT/JP2011/062044
(87) International publication number: WO 2011/149001

(57) **Abstract**

Disclosed is a transmission interference microscope that provides a degree of freedom to a region being observed while obtaining pure transmission information, and obtains highly-accurate interference images at high magnification under optimized radiation conditions. An electron beam emitted from an electron source 1 is split by a biprism 11 positioned under a converging lens 3, and enters objective lenses 4 as an electron beam 6 passing through a sample and an electron beam 7 passing through a vacuum. The electron beams are bent at the front magnetic fields of the objective lenses 4, and are emitted as a collimated beam in a state in which the sample location and vacuum are each appropriately are left a space.

## Description

### [Technical Field]

The present invention relates to a charged particle beam interference apparatus and relates to a transmission interference microscope using an electron beam.

### [Background Art]

An electron beam biprism interference apparatus measures a phase shift of an electron beam to quantitatively measure an electromagnetic field of a substance or an electromagnetic field in a vacuum.

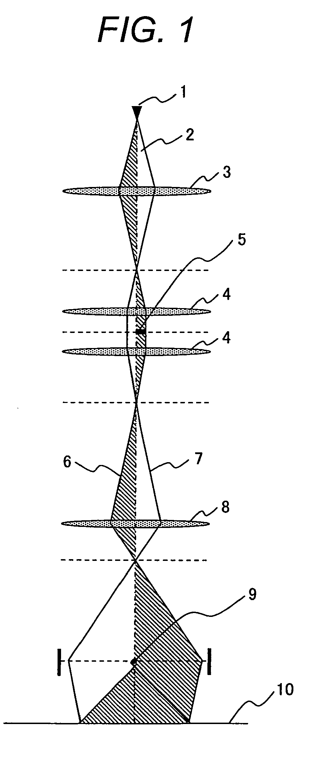

- Figure 1 shows an interference optical system used in a conventional electron beam holography method.

In Fig. 1, an electron beam 2 emitted from an electron source 1 runs as shown in the figure while being converged by a converging lens 3 and then passing through objective lenses 4.

A sample 5 is placed on one side of an optical axis between the objective lenses 4; an electron beam 6 which has transmitted (passed) through the sample and an electron beam 7 which has passed through a vacuum without passing through the sample are magnified with a magnifying lens 8, bent inward by a biprism 9, and detected on a screen 10 as interference fringes. A phase shift of the electron beam is obtained from the interference fringes.

In this method, the electron beam 6 passing through the sample and the electron beam 7 passing through the vacuum are next to each other at the sample location, thus the smaller an electron beam radiation region becomes, the closer a distance between those electron beams from each other, which limits an observation region to only an edge portion of the sample.

In addition to this problem of limiting the observation region, there has been another problem, that is, the problem that an electrical charge on the sample resulting from the converged electron beam being irradiated thereon, affects the electron beam 7 passing through the vacuum, and thereby making complete interference fringes difficult to be obtained. To solve this problem, the electron beam passing through the vacuum and the electron beam passing through the sample need to be left a space therebetween on the same plane as the sample.

A method for splitting an electron beam with a biprism disposed in an irradiation system to irradiate different regions on a level of a sample has been proposed as a scanning interference electron microscope in JP 2006-164861A.

In this method, the vacuum region and the sample are irradiated on the level of the sample by electron beams using a converging electron probe, then the interference fringes of the electron beam passing through the vacuum and the electron beam passing through the sample are detected by a detector in the lower side, and while obtaining phrase information, the probe or the sample is moved for scanning the sample to obtain information on an electromagnetic field within the level of the sample.

This method has some advantages such as data can be easily obtained once its conditions are set, magnification is easily changed, and an S/N ratio is high. On the other hand, in this method, the sample is irradiated by a converged electron beam and the information on the electromagnetic field is obtained for the entire region irradiated with a cone-shaped electron probe at a given observation point during scanning, consequently, when the sample has a thickness, a resolution becomes greater for the diameter of the cone-shaped electron probe, which makes the method unsuitable for application to a technique requiring a pure transmission image such as a tomography method.

In order to easily perform high resolution tomography analysis by an electron beam holography method without much influence from the electrostatic charge of the sample, it is to be desired that the sample should be irradiated with a collimated beam while the electron beam passing through a vacuum and the electron beam passing through the sample are left a space therebetween on the level of the sample. However, such desired could not have been reached with a conventional holography method or a conventional scanning interference electron microscope.

### [Citation List]

### [Patent Documents]

[Patent Document 1]
   JP 2006-216345A
[Patent Document 2]
   JP 2006-164861A
[Patent Document 3]
   JP2006-313069A

### [Summary of Invention]

### [Technical Problem to be solved by the invention]

The present invention is to solve the above-mentioned problem in the method of irradiating charged particles onto a sample in an interference apparatus, provide a degree of freedom to an observation region while obtaining pure transmission information, and obtain highly accurate interference images at high magnification under optimized irradiation conditions.

### [Means for solving the Problem]

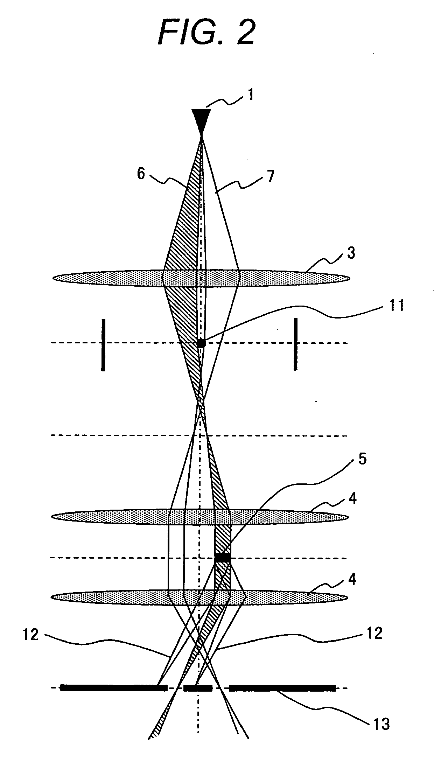

In order to solve the above-mentioned problem, the invention to be provided is the following means. A schematic view of the invention is shown in Fig. 2.

In Fig. 2, an electron beam emitted from the electron source 1 is split by a biprism 11 positioned under a converging lens 3 and enters objective lenses 4 as an electron beam 6 passing through a sample and the electron beam 7 passing through a vacuum. These electron beams are bent in a front magnetic field of the objective lenses 4, and irradiate the sample location and the vacuum on the level of the sample with collimated beams respectively while keeping an appropriate distance from each other.

Diffracted waves 12 diffracted by periodicity of the sample is cut out with an objective aperture 13 having two apertures for allowing only the electron beam 7 passing through the vacuum and the electron beam 6 passing through the sample to pass through, so that no diffracted waves reach a screen. Note that the objective aperture having two apertures cab be optionally added therein or removed therefrom in accordance with purposes.

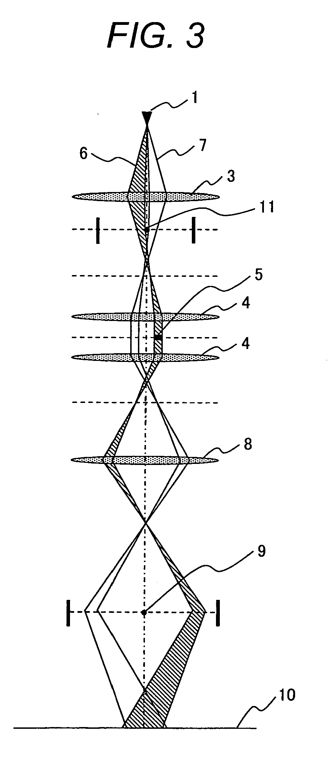

Figure 3 shows an overall view of an interference optical system used in an electron beam holography method according to the present invention.
The diffracted waves 12 and the objective aperture 13 having two apertures are not illustrated in Fig. 3. The electron beam 6 passing through the sample and the electron beam 7 passing through the vacuum, which runs in the respective paths illustrated in Fig. 2, are respectively magnified with the magnifying lens 8 and bent with the biprism 9 to make interference fringes on the screen 10. Since there already is an established generally known method for electron beam detection and for phase analysis from the detected interference fringes, it is not particularly described here.

### [Advantageous Effects of Invention]

According to the present invention, the electron beam 6 passing through the sample and the electron beam 7 passing through the vacuum are adjustable so as to be left a space at a given distance therebetween, and the sample can be irradiated by nearly collimated beams. The present invention can solve the problem in the method of irradiating charged particles onto the sample in the interference apparatus, and can provide a degree of freedom to the observation region while obtaining the information on transmission by the collimated beams. The present invention allows obtaining the electron beam 7 which passes through the vacuum without being affected by the electrostatic charge of the sample under optimized irradiation conditions, and allows obtaining highly accurate interference images at high magnification.

### [Brief Description of Drawings]

[Fig. 1] Illustrated is a schematic view of an interference optical system used in a conventional electron beam holography method.
[Fig. 2] Illustrated is a schematic view of an interference optical system around an irradiation system and objective lenses used in an electron beam holography method according to the present invention.
[Fig. 3] Illustrated is a schematic view of an entire interference optical system used in the electron beam holography method according to the present invention.
[Fig. 4] Illustrated is a schematic view of an electron beam holography apparatus according to Example 1 of the present invention.
[Fig. 5] Illustrated is a schematic view of an objective aperture having two-apertures in the electron beam holography apparatus according to the present invention.

### [Description of Embodiments]

Embodiments of the present invention will be described below with reference to figures.

### [Example 1]

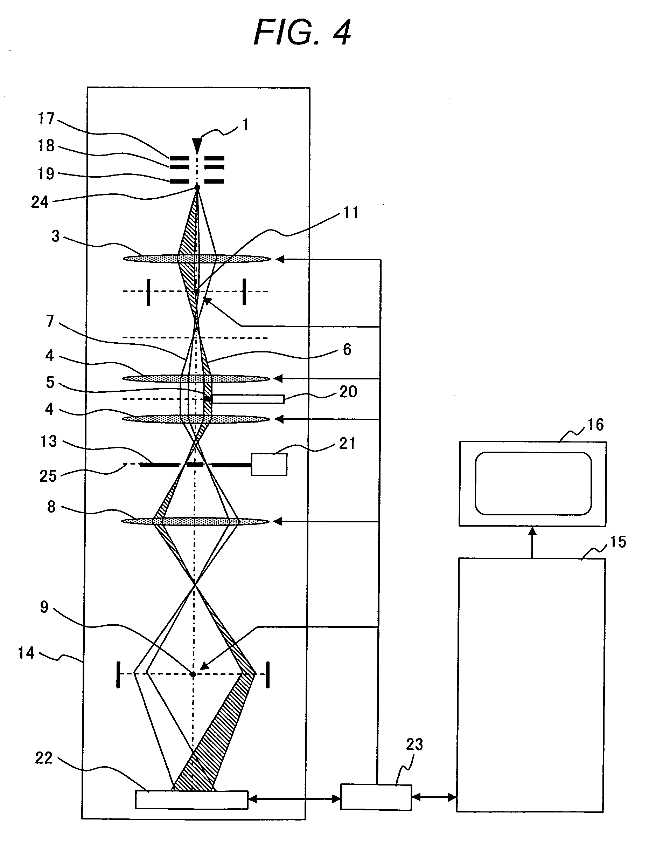

Figure 4 is a schematic view of an electron beam holography apparatus according to Example 1 of the present invention.

The electron beam holography apparatus according to the present invention has, in the same manner as a general-purpose interference microscope, a mirror body 14, a control PC 15, and a monitor 16, and the mirror body 14 is evacuated by an evacuating device not illustrated in the figure. The mirror body 14 comprises an electron source 1, a first extraction electrode 17, a second extraction electrode 18, an acceleration electrode 19, a converging lens 3, a biprism 11, objective lenses 4, a sample micro-moving mechanism 20, an objective aperture 13 having two apertures, an objective aperture micro-moving mechanism 21, a magnifying lens 8, a biprism 9, and an electron beam detector 22. The lenses, the biprisms, the sample micro-moving mechanism, the objective aperture micro-moving mechanism, and the electron beam detector are controlled by the control PC 15 through a D/A converter 22 respectively.

The control PC 15 has information input devices such as a keyboard and a mouse not illustrated in the figure, and users of the apparatus can use these devices and Graphical User Interface (GUI) software installed on the control PC 15 to control the apparatus. A constitution other than the biprism 11, the biprism 9, and the objective aperture 13 having two apertures has nearly the same as a normal general-purpose interference microscope, and it has a deflecting coil and a stigmator not illustrated in the figure.

A path of an electron beam according to the present embodiment will be described. An electron beam emitted from the electron source 1 is once converged at a hypothetical electron source 24 and then runs downward as illustrated in Fig. 4 in the mirror body 14 while diverging again.

After the electron beam is converged with the converging lens 3, the electron beam is split by the biprism 11 positioned under the converging lens. The biprism 11 can be applied with a given voltage by the control PC 15 to freely control a distance between the electron beam 6 passing through the sample and the electron beam 7 passing through a vacuum on the level of the sample 5 between the objective lenses.

The sample 5 can be moved to a given location with the sample micro-moving mechanism 20 to change an observation region of the sample. The sample micro-moving mechanism 20 may function only by a mechanical movement, or may have a voltage mechanism including a mechanical movement and a piezo element.

When the sample has a periodic structure, the electron beam passing through the sample is diffracted to make a diffraction spot on a back focal plane of the objective lenses. The electron beam interference apparatus needs the electron beam 6 passing through the sample and the electron beam 7 passing through the vacuum to make interference fringes. However, in some cases, the diffraction wave may not be a necessary electron beam component. Rather, in high resolution observation, the electron beam 6 passing through the sample, the electron beam 7 passing through the vacuum, and the diffraction wave may interfere with each other to create noise when a reproduced image is generated from the interference fringes.

In the electron beam holography apparatus according to the present invention, the electron beam 6 passing through the sample and the electron beam 7 passing through the vacuum since are focused on a back focal plane 25 of the objective aperture respectively, the objective aperture is provided with two apertures for allowing the electron beam 6 passing through the sample and the electron beam 7 passing through the vacuum to pass through respectively. In addition, the objective aperture 13 needs to have a several patterns of two apertures each having a different distance between the apertures, because when a distance between the electron beam 6 passing through the sample and the electron beam 7 passing through the vacuum on the level of the sample location is changed, the distance between them on the back focal plane 25 is also changed.

The objective aperture should be changed in accordance with situations. The objective aperture micro-moving mechanism 21 is operated with the control PC 15 to set the objective aperture to be an appropriate distance between the two apertures and locations of the two. Depending on the sample structure, a direction of the interference fringes with respect to the sample, and a positional relationship between the electron beam 6 passing through the sample and the electron beam 7 passing through the vacuum with respect to the sample, may need to be rotated on the level of the sample. In this case, it is effective to provide a mechanism for rotating the entire objective aperture 13 having two apertures or to provide an objective aperture having several sets of two apertures with different positional relationships.

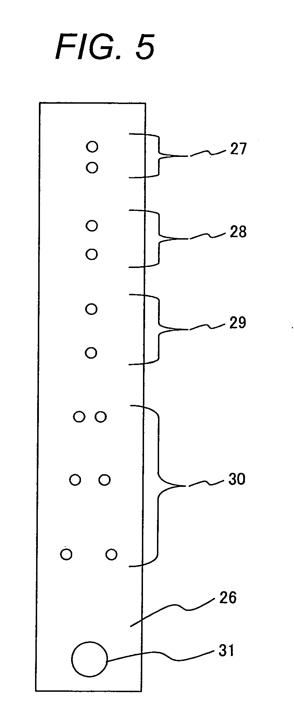

Figure 5 shows an example of an objective aperture plate having several sets of two apertures. The objective aperture plate 26 has a pattern A 27, a pattern B 28, and a pattern C 29 each having different distances between two apertures, and has lateral patterns 30 for the above-mentioned patterns A to C in a direction different from the patterns 27 to 29.

These patterns allows the electron beam 6 passing through the sample and the electron beam 7 passing through the vacuum to be passed through any one of the several set of two apertures while cutting out diffraction waves even when the condition of an electron beam irradiation for the sample is changed. Each position of the objective aperture can be stored as a coordinate of the aperture pattern in the control PC 15 in the same manner as a practical example of a motor drive objective aperture, so that the aperture pattern can be easily changed by retrieving the coordinate of the aperture pattern.

When using a specific objective lens current, a positional relationship and a distance between the electron beam 6 passing through the sample and the electron beam 7 passing through the vacuum on the level of the sample are determined by the lens current of the converging lens 3, the direction of the biprism 11, and the potential of the biprism 11.

Conversely, when the aperture pattern of the objective aperture is already determined, it is possible to allow the electron beam 6 passing through the sample and the electron beam 7 passing through the vacuum to pass through the two apertures of the predetermined pattern by adjusting the lens current of the converging lens 3, the direction of the biprism 11, and the potential of the biprism 11.

Furthermore, material analysis is often done for observations of the same position under different magnifications. In this case, the lens current of the converging lens 3 needs to be changed to change brightness. When only the lens current of the converging lens 3 is changed from a certain adjusted state of the apparatus, an electron beam since is converged while rotating in a spiral manner in the microscope, change is not only the positional relationship between the electron beam 6 passing through the sample and the electron beam 7 passing through the vacuum on the level of the sample location, but also the positional relationship between the electron beam 6 passing through the sample and the electron beam 7 passing through the vacuum on the back focal plane. Therefore, in order to keep the same positional relationship between the electron beam 6 passing through the sample and the electron beam 7 passing through the vacuum on the level of the sample even if the lens current of the converging lens 3 is changed to change the brightness, the direction of the biprism needs to be rotated in-plane by coordinating with the converging lens current.

This coordinating operation is determined by each specific apparatus, so a data file of the coordinating operation can be stored in the control PC 15 and can be retrieved at the time of changing the converging lens current to rotate the biprism. This allows a user to change the brightness without stress, and the relationship between the electron beam 6 passing through the sample and the electron beam 7 passing through the vacuum on the level of the can be easily maintained.

The electron beam 6 passing through the sample and the electron beam 7 passing through the vacuum are each magnified with the magnifying lens 8, are bent with the biprism 9, and make interference fringes on the electron beam detector 22. A plurality of magnifying lenses and biprisms, not illustrated in the figure, may be disposed between the sample and the electron beam detector 22 to provide an arbitrary interference condition.

An example of a holography electron microscope provided with a plurality of biprisms between the sample and the electron beam detector 22 is disclosed in detail in JP 2006-216345A and JP 2006-313069A, thus no further description is stated here. As described that a specific interference condition can be provided stably by, in an irradiation system, coordinating the direction of the lens current of the irradiation system and the direction of the biprism of the irradiation system, it is effective in an imaging system also to coordinate the direction of the lens current of the imaging system and the direction of the biprism of the imaging system and to rotate the directions accordingly in the same manner.

These coordinating conditions are stored in the control PC 15 and retrieved as necessary for appropriate operation. The interference fringes detected with the electron beam detector 22 is instantly transmitted through the D/A converter 23 to be processed with the control PC 15 for reproduction, and a reproduced image is displayed on the monitor 16. There are already established known methods for the reproduction process, so no detail of the process is described here.

### [Reference Signs List]

1:electron source, 2:electron beam, 3:converging lens, 4:objective lens, 5:sample, 6:electron beam passing through a sample, 7:electron beam passing through a vacuum, 8:magnifying lens, 9:biprism, 10:screen, 11:biprism, 12:diffracted wave, 13:objective aperture having two apertures, 14:mirror body, 15:control PC, 16:monitor, 17:first extraction electrode, 18:second extraction electrode, 19:acceleration electrode, 20:sample micro-moving mechanism, 21:objective diaphragm micro-moving mechanism, 22:electron beam detector, 23:D/A converter, 24:hypothetical electron source, 25:back focal plane, 26:objective aperture plate having two apertures, 27:pattern A, 28:pattern B, 29:pattern C, 30:lateral patterns, 31:screw hole for fixing

## Claims

1. A transmission interference microscope comprising: a light source of a charged particle beam; an irradiation optical system configured to irradiate an electron beam emitted from the light source to a sample; an irradiation system biprism provided between the light source and the sample, the irradiation system configured to irradiate the respective split electron beams to a sample location and a vacuum location on a level of the sample; a mechanism configured to hold the sample; an imaging lens system configured to form an image of the sample; at least one stage of an imaging system biprism provided in the imaging lens system; and a device configured to observe or record interference fringes of the electron beam passing through the vacuum location and the electron beam passing through the sample location on the level of the sample.

2. The transmission interference microscope according to claim 1, wherein the microscope is provided with an objective aperture having two apertures

3. The transmission interference microscope according to claim 1, wherein the microscope has a function of rotating the biprisms around a light axis, coordinating with an irradiation system lens current.

4. The transmission interference microscope according to claim 1, wherein the microscope has a function of rotating an entire objective aperture around a light axis, coordinating with an irradiation system lens current.

5. The transmission interference microscope according to claim 1, wherein a positional relationship of the two apertures can be changed.

6. The transmission interference microscope according to claim 1, wherein the microscope has a function of changing each fringe spacing in the interference fringes by changing a deflection angle between the electron beam passing through the vacuum location and the electron beam passing through the sample.

7. The transmission interference microscope according to claim 1, wherein the microscope is provided with a storage for storing information for performing a predetermined coordinated operation of the irradiation system lens current and the rotation of the biprisms around the light axis for a specific purpose, and a control device configured to make it possible to perform the coordinated operation determined in accordance with the stored information when the rotation of the biprisms around the light axis is coordinated with the irradiation system lens current.

8. The transmission interference microscope according to claim 1, wherein the microscope is provided with a storage for storing information for performing a predetermined coordinated operation of the irradiation system lens current and the rotation of an objective aperture around the light axis for a specific purpose, and a control device configured to make it possible to perform the coordinated operation determined in accordance with the stored information when the rotation of the objective aperture around the light axis is coordinated with the irradiation system lens current.

9. The transmission interference microscope according to claim 1, wherein the microscope is provided with a storage for storing information for performing a predetermined coordinated operation of the imaging system lens current and the rotation of the biprisms around the light axis for a specific purpose, and a control device configured to make it possible to perform the coordinated operation determined in accordance with the stored information when the rotation of the biprisms around the light axis is coordinated with the imaging system lens current.
